# EUROPEAN PATENT APPLICATION

(11) **EP 3 599 635 A1**
(43) Date of publication of application: **29.01.2020**
(21) Application number: 18185292.2
(22) Date of filing: 24.07.2018
(51) Int. Cl.: H01L 21/336, H01L 29/78

(54) **PATTERNING FIN STRUCTURES INTO A SEMICONDUCTOR SUBSTRATE**

(71) Applicant: IMEC vzw, 3001 Leuven (BE)
(72) Inventor: MILENIN, Alexey, 3001 Leuven (BE); BAUDOT, Sylvain, 3001 Leuven (BE)
(74) Representative: DenK iP

(57) **Abstract**

A method for forming fin structures (400) of a selected height (h₂) into a semiconductor substrate (100), comprising:
a. providing the semiconductor substrate (100) masked by a first mask comprising openings (300) in the shape of trenches;
b. etching the semiconductor substrate (100) down to a first depth (di), thereby forming intermediate fin structures (410) having an intermediate height (hi);
c. providing a second mask (500) over the first mask (200), the second mask (500) masking at least partially a first subset (403) of the intermediate fin structures (410) while not masking a second subset (404) thereof;
d. etching at least partially the second subset (404) of the intermediate fin structures (410);
e. removing the second mask (500); and
f. etching the semiconductor substrate (100) down to a second depth (d₂) selectively with respect to the first mask (200), thereby forming the fin structures (400).

## Description

### Technical field of the invention

The present invention relates to the formation of fin structures in a semiconductor substrate and more particularly to schemes for applying patterning masks in this formation.

### Background of the invention

During the formation of fin structures in semiconductor technology, there is often a need to further modify an initial fin pattern. This is typically achieved by applying additional patterning techniques on the initial fin pattern. For example, particularly in the advanced nodes of 10 nm, 7 nm and lower, an initial fin pattern can be obtained through a multiple-patterning technique, such as self-aligned double patterning (SADP), self-aligned quadruple patterning (SAQP) or self-aligned octuple patterning (SAOP). The initial fin pattern then obtained does typically not consist only of straight parallel lines (fins), but further comprises loops connecting one line to another line. Depending on the multiple-patterning technique that is used, these loops may be such that the initial pattern consists of sets of concentric pattern structures. In order to eventually obtain the parallel fin structures which are most commonly desired, these loops must thus be removed. This removal of the loops can be referred to as 'CUT' patterning.

Furthermore, there is also often a desire to modify the initial fin pattern so as to remove one or more of the fin structures. For example, the terminal fin structure of the initial fin pattern, which are flanked by only one other fin structures rather than two, may typically experience different conditions during formation than the inner fin structures, so that these terminal fin structures have characteristics (e.g. shape) differing from the inner lines. In order to eventually obtain the uniform fin structures which are most commonly desired, these terminal fin structures are thus typically removed. Moreover, the fin design that is envisioned may require that one or more of the inner fin structures are removed from the initial fin pattern. The removal of one or more of the fin structures (be it outer or inner fin structures) can be referred to as 'KEEP' patterning.

Different schemes for applying this CUT and KEEP patterning are known. A first scheme may be referred to as 'CUT&KEEP-first'. In this scheme, the CUT and KEEP patterning are performed at the level of the initial fin pattern mask (e.g. directly after this mask is patterned with a multiple-patterning technique) and prior to this initial fin pattern being transferred into the semiconductor substrate. After this initial fin pattern mask is modified with the desired CUT and KEEP patterning techniques, the modified fin pattern is then transferred into the semiconductor substrate. An advantage is that this approach is relatively simple. However, a considerable drawback is that, even if the outer fins structures in the initial fin pattern were removed and fully uniform fin structures were obtained in the modified fin pattern, upon transferring the modified fin pattern into the semiconductor substrate, terminal fin structures are again obtained which have undergone different formation conditions. These terminal fin structures are thus typically not the same as the inner fin structures (cf. comparative example).

Another scheme may be referred to as 'CUT&KEEP-last'. In this scheme, the initial fin pattern is first transferred into the semiconductor substrate and the loops and fin structures are fully patterned therein, subsequently the CUT and KEEP patterning are performed on these fully patterned loops and fin structures. An advantage of this scheme is that the fin structures which are eventually obtained can be uniform. A disadvantage is that this scheme is more complicated to apply in practice and typically further requires additional steps as compared to CUT&KEEP-first. Indeed, the removal of the loops and patterned fin structures at this stage requires a much deeper etching than is the case for CUT&KEEP-first, meanwhile, the etch selectivity with respect to the fin structures which are to remain must be maintained; this is typically not trivial to achieve. Furthermore, the patterned fin structures typically have high aspect ratios and are therefore relatively delicate, as such applying patterning masks directly thereon can easily lead to them collapsing. Additional structural support is therefore typically provided as follows: after the initial fin pattern is transferred into the semiconductor substrate and the loops and fin structures have been fully formed, the trenches therebetween are typically filled with a shallow trench isolation (STI) prior to applying the CUT and KEEP patterning. However, this also means that after the CUT and KEEP patterning, the STI filling and chemical-mechanical planarization (CMP) thereof must be performed a second time, in order to fill up the spaces where the loops and fin structures have been removed.

There is thus still a need in the art for better schemes for applying patterning masks in the formation of fin structures in a semiconductor substrate.

### Summary of the invention

It is an object of the present invention to provide good methods and associated intermediate structures for forming fin structures into a semiconductor substrate. This objective is accomplished by a method and an intermediate structure according to the present invention.

It is an advantage of embodiments of the present invention that fin structures (including the terminal fin structures) having all the same dimensions (or less differences in dimensions between the different fin structures than in a CUT&KEEP-first scheme) can be formed in a semiconductor substrate.

It is an advantage of embodiments of the present invention that fin structures (including the terminal fin structures) having no protrusion (or less protrusion than in a CUT&KEEP-first scheme) in a top portion thereof can be formed in a semiconductor substrate.

It is an advantage of embodiments of the present invention that the method is relatively straightforward to use and does not require a large number of steps, especially when compared to a CUT&KEEP-last scheme. It is a further advantage of embodiments of the present invention that the method can be performed in an economical fashion.

It is an advantage of embodiments of the present invention that the method can be flexibly adapted to suit a number of different needs, e.g. the method be performed after a CUT patterning of the prior art (hereinafter referred to as a CUT-first & KEEP-middle scheme), or the method can be used to perform both CUT and KEEP patterning (hereinafter referred to as a CUT&KEEP-middle scheme), etc.

It is an advantage of embodiments of the present invention that the top part of the fin structure will stay straight, while second portion of the fin structures can slightly flare towards the bottom.

It is an advantage of embodiments of the present invention that the risk of the fin structures collapsing during their formation is reduced, especially when compared to a similar scheme applied after full depth fin patterning.

It is an advantage of embodiments of the present invention that the method may be suited for patterning at advanced nodes (e.g. the 10 nm, 7 nm and lower nodes), e.g. where the aspect ratio of the fin structures is high and the pitch between fin structures is low.

In a first aspect, the present invention relates to method for forming fin structures (400) of a selected height (h₂) into a semiconductor substrate (100), comprising:
a. providing the semiconductor substrate (100) masked by a first mask (200) comprising openings (300) in the shape of trenches;
b. etching the semiconductor substrate (100) down to a first depth (di) selectively with respect to the first mask (200), thereby forming intermediate fin structures (410) having an intermediate height (hi), smaller than the selected height (h₂) into the semiconductor substrate (100);
c. providing a second mask (500) over the first mask (200), the second mask (500) masking at least partially a first subset (403) of the intermediate fin structures (410) while not masking a second subset (404) thereof;
d. etching at least partially the second subset (404) of the intermediate fin structures (410);
e. removing the second mask (500); and
f. etching the semiconductor substrate (100) down to a second depth (d₂) selectively with respect to the first mask (200), thereby forming the fin structures (400) having the selected height (h₂) from the intermediate fin structures (410).

In a second aspect, the present invention relates to an intermediate structure for forming fin structures (400) of a selected height (h₂) into a semiconductor substrate (100), comprising:
i. a semiconductor substrate (100) having intermediate fin structures (400) therein;
ii. a first mask (200) masking all intermediate fin structures (400) and comprising openings (300) aligned with spaces between the intermediate fin structures;
iii. a second mask (500) over the first mask (200), the second mask (500) masking at least partially a first subset (403) of the intermediate fin structures (410) while not masking a second subset (404) thereof.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Figs. 1 to 12 show schematic vertical cross-sections of structures at different stages in an exemplary method according to the present invention.
Fig. 13 shows scanning an electron microscopy (SEM) image of a sample obtained in accordance with a prior art method.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable with their antonyms under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. Thus, the scope of the expression "a device comprising means A and B" should not be interpreted as being limited to devices consisting only of components A and B. It means that with respect to the present invention, the only relevant components of the device are A and B.

Similarly, it is to be noticed that the term "coupled", also used in the claims, should not be interpreted as being restricted to direct connections only. The terms "coupled" and "connected", along with their derivatives, may be used. It should be understood that these terms are not intended as synonyms for each other. Thus, the scope of the expression "a device A coupled to a device B" should not be limited to devices or systems wherein an output of device A is directly connected to an input of device B. It means that there exists a path between an output of A and an input of B which may be a path including other devices or means. "Coupled" may mean that two or more elements are either in direct physical or electrical contact, or that two or more elements are not in direct contact with each other but yet still co-operate or interact with each other.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly, it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practised without these specific details. In other instances, well-known methods, structures and techniques have not been shown in detail in order not to obscure an understanding of this description.

Reference will be made to transistors. These are devices having a first main electrode such as a drain, a second main electrode such as a source and a control electrode such as a gate for controlling the flow of electrical charges between the first and second main electrodes.

The following terms are provided solely to aid in the understanding of the invention.

As used herein, and unless otherwise specified, fin structures are a plurality of fins separated by inter-fin spaces. Inter-fin spaces are also referred to as "inter-fin trenches" or "trenches".

As used herein, and unless otherwise specified, a terminal fin structure is a fin structure which is flanked by no more than one adjacent fin structure in a set of equidistant fin structures. As used herein, and unless otherwise specified, an inner fin structure is a fin structure which is flanked by two adjacent fin structures in a set of equidistant fin structures. When the first mask is obtained by a multiple-patterning technique, the number of terminal intermediate fin structures obtained by etching the semiconductor substrate selectively with respect to the first mask is typically equal to 2.

As used herein, and unless otherwise specified, a height of a fin structure (e.g. a selected height and/or an intermediate height) is a distance between a top of the fin structure and a plane coplanar with a bottom of an adjacent inter-fin space.

As used herein, and unless otherwise specified, a depth of etching into a semiconductor substrate is measured from a top surface of the semiconductor substrate (e.g. prior to the etching) down to the lowest level of said etching into the semiconductor substrate.

In a first aspect, the present invention relates to a method for forming fin structures (400) of a selected height (h₂) into a semiconductor substrate (100), comprising:
a. providing the semiconductor substrate (100) masked by a first mask (200) comprising openings (300) in the shape of trenches;
b. etching the semiconductor substrate (100) down to a first depth (di) selectively with respect to the first mask (200), thereby forming intermediate fin structures (410) having an intermediate height (hi), smaller than the selected height (h₂) into the semiconductor substrate (100);
c. providing a second mask (500) over the first mask (200), the second mask (500) masking at least partially a first subset (403) of the intermediate fin structures (410) while not masking a second subset (404) thereof;
d. etching at least partially the second subset (404) of the intermediate fin structures (410);
e. removing the second mask (500); and
f. etching the semiconductor substrate (100) down to a second depth (d₂) selectively with respect to the first mask (200), thereby forming the fin structures (400) having the selected height (h₂) from the intermediate fin structures (410).

In embodiments, the fin structures may be for forming a fin field effect transistor (FinFET). Hence, the method of the present invention may further comprise forming a FinFET from one or more of the fin structures having the selected height.

In embodiments, the semiconductor substrate may be formed of Si, Ge, Si:Ge, or multilayers thereof. Preferably, it is formed of Si or Ge.

In embodiments, the etching performed in step b and/or d and/or f may be a dry etching (e.g. a plasma etching). Preferably all of the etching steps are dry etching steps. Dry etching is advantageous because it is more directional than wet etching. Typically, the dry etching steps are performed perpendicularly to the substrate top surface.

In embodiments, the first mask may comprise an initial fin pattern, i.e. a pattern of lines suitable for forming fins once transferred in the substrate. Typically, these lines are a plurality of lines. Typically, they are parallel to each others.

In embodiments, the pitch of these lines may be from 50 to 200 nm.

Their initial pitch may take various values but as an example, for SAQP flow, it is typically from 84 to 100 nm after lithography.

In embodiments, the width of these lines may be from 20 to 100 nm. The width of these lines may for instance be from 40 to 50 nm directly after lithography (typical of a SAQP flow), and latter this width may typically be trimmed down to 32± 4nm after a dry etch. The width can take various values and depend on the final fin CD target. This width can be adapted by selecting for instance a particular spacer thicknesses during the multiple-patterning process. Optimal values for such parameters are different for different multiple-patterning techniques such as SADP and SAOP flows.

In embodiments, the "first mask" may be obtained by using a multiple-patterning technique. More precisely, in embodiments, the "first mask" may represent the remaining stack and the pattern obtained by using a multiple-patterning technique at the stage prior to fin etch. The technique could for instance be a as self-aligned double patterning (SADP), self-aligned quadruple patterning (SAQP) or self-aligned octuple patterning (SAOP).

In embodiments, the first mask may comprise dielectric layers or other materials. For instance, it may comprise an oxide material. In embodiments, the first mask may comprise one or more layers selected from a pad oxide layer (typically an SiO₂ layer which may for instance be deposited by chemical vapor deposition (CVD); it typically has a thickness of from 1 to 8 nm), a pad nitride layer (also called buffer layer, it is typically a Si₃N₄ layer which may also for instance be deposited by CVD; it typically has a thickness of from 15 to 40 nm), one or more hardmask layers (e.g. an oxide hardmask layer; the oxide hardmask layer is typically an SiOx layer such as a SiO₂ layer; the oxide hardmask layer typically has a thickness of from 20 to 60 nm; it may also be deposited by CVD, an amorphous silicon layer (it typically has a thickness of from 15 to 30 nm; it can for instance be provided by CVD, preferably by plasma-enhanced CVD (PECVD), and a patterned dielectric layer (typically a patterned Si₃N₄ layer; it may be patterned e.g. with SAQP; its thickness may be in the range of 20 - 40nm). In embodiments, the first mask may comprise a patterning stack (e.g. the first mask may comprise a plurality of layers stacked on top of each other). In embodiments, the patterning stack may comprise a pad oxide layer, a nitride pad layer thereon, an oxide hardmask layer thereon, an amorphous silicon layer thereon, and a patterned dielectric layer (e.g. an SAQP patterned nitride layer) thereon. In embodiments, the first mask (which may comprise (or consist in) the patterning stack) may be in direct contact with the semiconductor substrate.

In embodiments, the trench-shaped openings in the first mask may have a width (e.g. a maximum width, preferably a constant width) of from 5 to 20 nm (e.g for final pitch of 25nm after SAQP), preferably from 10 to 16 nm. In embodiments, the trench-shaped openings may have an aspect ratio (width : length) of between 1:30 and 1:3. In embodiments, the trench-shaped openings may have a length of from 15 to 600 nm, preferably from 21 to 450 nm. In embodiments, the trench-shaped openings may be open-ended (e.g. open at opposing longitudinal ends, for example as obtained after a CUT-patterning).

In embodiments, the first depth (in the substrate, excluding HM stack) may measure between 20 and 100 nm, preferably between 30 and 70 nm, such as 50 nm (typically, it is determined by the active fin high requirement, which is currently set at about 50nm but can be increased for high current/power applications). In embodiments, the etching in step b may form intermediate fin structures. In embodiments, the intermediate fin structures may have an intermediate height. In embodiments, the intermediate height may measure between 20 and 100 nm, preferably between 30 and 70 nm, such as 50 nm. In embodiments, the intermediate height may substantially correspond to the first depth.

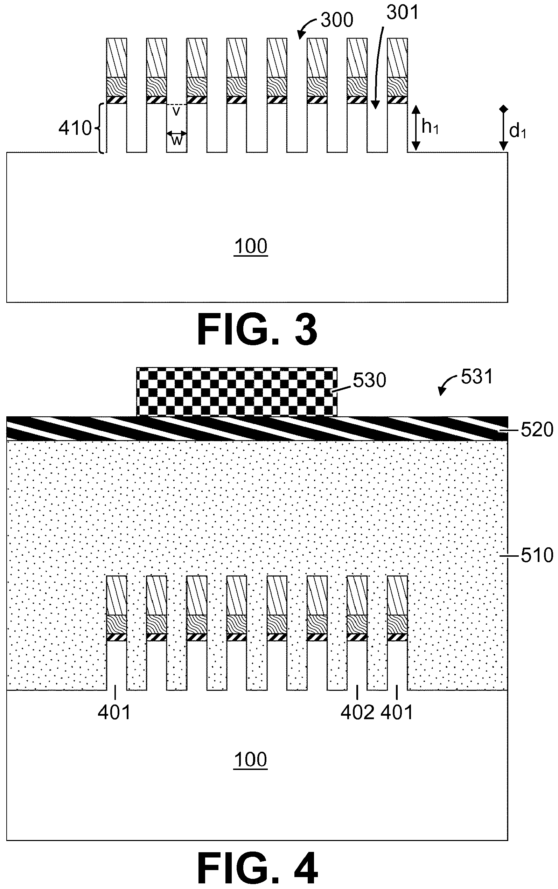

In embodiments, the intermediate fin structures may have a straight profile (e.g. when observed in a cross-section taken perpendicularly to their longitudinal direction, like in Fig. 3).

In embodiments, the etching in step b may be performed such that a volume v thereby etched-away (i.e. the volume by which one trench is downwardly extended) has a uniform width w (this is depicted in Fig. 3).

In embodiments, when a fin structure of a selected height will be used for forming a FinFET, the channel of the FinFET may be advantageously located in the portion of the fin structure corresponding to the intermediate fin structure, i.e. in the top portion of the fin structures of a selected height when the fin structures are pointing upward.

In embodiments, each intermediate fin structure may have a width (e.g. a maximum width, preferably a constant width) of from 5 to 20 nm, preferably from 8 to 12 nm. The pitch may be for instance from 20 to 30 nm (typically 25 nm). For instance, when 9-10 nm fin width is targeted, 16-15nm trench width can be used to get a pitch of 25 nm). In embodiments, each intermediate fin structure may have an aspect ratio (width : height; i.e. fin CD: fin height) of between 1:12 and 1:20. The length of the intermediate fin structures can take a large range of values. In embodiments, each intermediate fin structure may have a length of from 15 to 600 nm, preferably from 21 to 450 nm. Such lengths are typical if a CUT-patterning is done already. If the CUT is performed after step b, other (longer) length are more typical. In embodiments, each intermediate structure may have a height of from 120 to 160 nm. The intermediate fin structures are typically a plurality of intermediate fin structures. They are typically parallel to one another. Loops may be present between intermediate fin structures, thereby linking them to one another.

In embodiments, the second mask may comprise a pattern for a KEEP-patterning (e.g. a pattern suitable for removing one or more intermediate fin structures, from the set of intermediate fin structures obtained after step b) and/or for a CUT-patterning (e.g. a pattern suitable for interrupting one or more intermediate fin structures; e.g. removing loops from said intermediate fin structures). In embodiments, the second mask may comprise one or more layers selected from a spin-on-carbon layer, a spin-on-glass layer and a resist layer (e.g. a photoresist layer). In embodiments, the second mask may comprise a patterning stack (e.g. the second mask may comprise a plurality of layers stacked on one another). In embodiments, the patterning stack may comprise the spin-on-carbon layer, the spin-on-glass layer on the spin-on-carbon layer and the resist layer on the spin-on-glass layer.

In embodiments, the method may further comprise a step b' after step b and before step c of filing a space between the intermediate fin structures with a filling material and a step e' after step e and before step f of removing the filing material from between the intermediate fin structures. When the second mask is a patterning stack comprising the spin-on-carbon layer, the spin-on-glass layer on the spin-on-carbon layer and the resist layer on the spin-on-glass layer, the the filling material is preferably a spin-on-carbon layer. In such a case, the filling material and the bottom layer of the patterning stack may be provided by providing a single spin-on-carbon layer which will first fill in the spaces between the intermediate fin sturctures, then raise above the first mask and cover the same (this can be seen in Fig. 4).

The second mask masks at least partially a first subset of the intermediate fin structures while not masking a second subset thereof. The second subset preferably comprises a terminal intermediate fin structure. Preferably, it comprises all terminal intermediate fin structures of the complete set. This is advantageous because terminal fin structures tend to be different, e.g. to have a different profile, from inner fin structures.

In embodiments, the fin structures may comprise one or more sets of equidistant fin structures, each set comprising and being confined by two terminal fin structures, each terminal fin structure having only one adjacent fin structure. In embodiments, etching at least partially the second subset of the intermediate fin structures in step d may comprise removing at least one of the terminal fin structures. In alternative or complementary embodiments, etching at least partially the second subset of the intermediate fin structures in step d may comprise removing at least one of the inner fin structures.

In embodiments, etching at least partially the second subset of the intermediate fin structures in step d may comprise reducing the height of the intermediate structures within that subset obtained in step b by 50% or more, preferably 70% or more, yet more preferably 90% or more.

In embodiments, steps c and d may be for performing either of a KEEP-patterning or a CUT-patterning. In these embodiments, steps c and d may optionally be repeated for performing the other of the KEEP-patterning and the CUT-patterning when a KEEP patterning or a CUT-patterning has already been performed.

In embodiments, repeating steps c and d may comprise:
- performing step c,
- partially performing step d (e.g. at least partially etching the first mask, but not etching at least partially the second subset of the intermediate fin structures),
- repeating step c, and
- fully performing step d.

In embodiments, steps c and d may be for simultaneously performing the KEEP-patterning and the CUT-patterning.

It was surprisingly found within the present invention that a modification of the pattern of the intermediate fin structures can advantageously be performed after the fin structures have been partially formed, but before they have been fully formed. Such a scheme may be referred to as 'CUT- and/or KEEP-middle', as compared to the CUT&KEEP-first and CUT&KEEP-last schemes as previously described. For example, performing a KEEP-middle patterning has the advantage of being relatively simple, as for example compared to a KEEP-last patterning. Furthermore, in a KEEP-middle pattering, terminal fin structures (which typically have different characteristics than the inner fin structures, e.g. in the form of a protrusion, cf. example 3), can be removed and the formation of the full fin structures can be continued with uniform first portions; this is e.g. particularly beneficial with respect to the KEEP-first scheme. Even if new protrusions would form in the bottom portion of the then terminal fin structure (i.e. in the portion formed during step d), these do not typically affect the performance of the fin structures as the active area (e.g. the channel in a FinFET) is typically located in the top portion (i.e. the portion formed during step b). Moreover, the partially formed fin structures (i.e. the intermediate fin structures which will form the top portion of the final fin structures) are typically less structurally delicate (e.g. through having a smaller aspect ratio) than the fully formed fin structures, as such CUT- and/or KEEP-middle patterning masks can be applied directly thereon, while keeping the risk of fin structure collapse low. The CUT- and/or KEEP-middle may therefore be considered as combining advantages from the CUT&KEEP-first and CUT&KEEP-last schemes.

It is to be noted that the present invention is not necessarily limited to a CUT&KEEP-middle scheme (cf. example 2), but covers any combination comprising at least a CUT-middle or a KEEP-middle. As such, e.g. in particular also a CUT-first & KEEP-middle scheme is envisioned (cf. example 1).

In embodiments, removing the second mask in step e may comprise completely removing all layers constituting said second mask.

In embodiments, step e may occur at least partially (e.g. completely) simultaneously with step d.

In embodiments, when a filling material was filled in a space between the intermediate fin structures, this material may be removed in a step e', directly following step e. Step e' may occur at least partially (e.g. completely) simultaneously with step d.

In embodiments, the second depth may measure at least 50 nm, preferably at least 70 nm, such as 120 nm. In embodiments, the second depth may be at least twice the first depth. In embodiments, the etching in step f may form a bottom portion of the fin structures. In embodiments, the bottom portion may have a width which flares towards the bottom. In embodiments, the etching in step f may be performed such that a volume thereby etched-away (i.e. the volume by which one trench is downwardly extended) has a width which tapers from the first depth to the second depth.

The flaring profile of the second portion can advantageously stabilize the fin structure and mitigate the collapse thereof.

In embodiments, the bottom and the top portion combined may have a selected height (e.g. the height that is selected for the final fin structures). In embodiments, the selected height may measure at least 50 nm, preferably at least 70 nm, such as 120 nm. In embodiments, the selected height may substantially correspond to the second depth. In embodiments, the fin structures may have a width (e.g. an average width or a minimum width) of from 5 to 20 nm, preferably from 7 to 15 nm. In embodiments, the fin structures may have an aspect ratio of between 1:30 and 1:3.

In embodiments, the method may further comprise a step g, after step f, of removing at least part of the first mask. In embodiments, removing the first mask may comprise completely removing some, but not all, layers constituting said first mask. In embodiments, step g may occur at least partially simultaneously with step f. In embodiments, the method may further comprise a step f', after step f, of providing a conformal protective layer over the semiconductor substrate. In embodiments, the protective conformal layer may be a dielectric layer. The conformal protective layer may advantageously improve etch selectivity during step g.

In embodiments, the method may further comprise a step, after step f, e.g. after step g, of filling the trenches between the fin structures with a dielectric (e.g. with a shallow trench isolation layer, STI). In embodiments, filling the trenches between the fin structures with the dielectric may comprise overfilling the trenches with the dielectric and subsequently planarizing the dielectric (e.g. using a chemical mechanical planarization, CMP).

In embodiments, any feature of any embodiment of the first aspect may independently be as correspondingly described for embodiments of the second aspect.

In a second aspect, the present invention relates to an intermediate structure for forming fin structures (400) of a selected height (h₂) into a semiconductor substrate (100), comprising:
i. a semiconductor substrate (100) having intermediate fin structures (400) therein;
ii. a first mask (200) masking all intermediate fin structures (400) and comprising openings (300) aligned with spaces between the intermediate fin structures;
iii. a second mask (500) over the first mask (200), the second mask (500) masking at least partially a first subset (403) of the intermediate fin structures (410) while not masking a second subset (404) thereof.

In embodiments, the the second subset comprises at least one terminal fin structures.

In embodiments, any feature of any embodiment of the second aspect may independently be as correspondingly described for embodiments of the second aspect.

The invention will now be described by a detailed description of several embodiments of the invention. It is clear that other embodiments of the invention can be configured according to the knowledge of the person skilled in the art without departing from the technical teaching of the invention, the invention being limited only by the terms of the appended claims.

### Example 1: patterning fin structures using a CUT-first & KEEP-middle scheme

Fin structures were patterned into a semiconductor substrate using a CUT-first & KEEP-middle scheme.

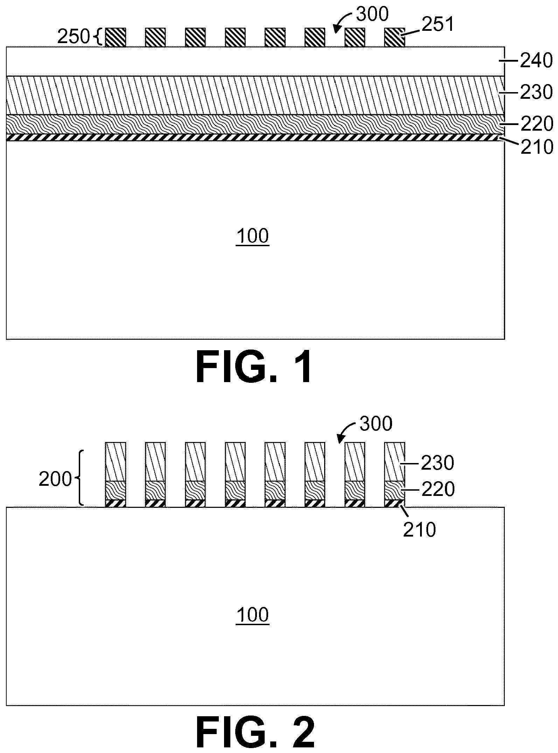

We now refer to Fig. 1. A structure was provided comprising a Si wafer as a semiconductor substrate (100), overlaid with a patterning stack (200) of a 4 nm pad oxide layer (210), a 20 nm Si₃N₄ pad layer (220), a 40 nm SiO₂ hardmask layer (230; e.g. provided by plasma enhanced chemical vapor deposition, PECVD), a 30 nm amorphous silicon (a-Si) layer (240; e.g. provided by PECVD) and a patterned Si₃N₄ layer (250). The patterned Si₃N₄ layer (250) comprised a pattern of lines (251) and trenches (300) therebetween, obtained through a multiple-patterning technique (e.g. self-aligned quadruple patterning, SAQP). The cross-section is taken perpendicularly to the longitudinal direction of these lines (251) A CUT patterning was performed (not depicted) on the patterned Si₃N₄ layer (250), e.g. to remove the loops therein. To this end, the patterned Si₃N₄ layer (250) was covered with a patterning stack comprising a spin-on-carbon (SoC) layer, a spin-on-glass (SoG) layer and a resist layer. The resist layer was patterned (e.g. photolithographically) with a suitable CUT pattern and the CUT pattern was transferred through the SoG, SoC and Si₃N₄ patterned layer using a dry etch, stopping on the a-Si layer (240), thereby applying the CUT patterning to the patterned Si₃N₄ layer (250). The etch chemistries used to etch through the SoG, SoC and to remove the exposed Si₃N₄ lines (251) were as commonly known in the art. For example, dielectric layers such as Si₃N₄ or SoG could be etched using a fluorocarbon-based plasma. An organic layer such as the SoC could be etched using an Ar/O₂- or SO₂/O₂- or H₂/N₂-based plasma, which can be selective to Si₃N₄ and SoG. After this pattern transfer, any remaining resist, SoG or SoC was stripped from the patterned hardmask layer (250).

We now refer to Fig. 2. The pattern of the patterned hardmask layer (250) was transferred through the a-Si layer (240), SiOₓ hardmask layer (230), Si₃N₄ pad layer (230) and pad oxide layer (210), by etching through the trenches (300) down to the semiconductor substrate (100). The etch chemistries used were as commonly known in the art. For example, the a-Si could be etched with a Cl₂-based or HBr-based plasma. The dielectric layers such as SiOₓ, Si₃N₄ and pad oxide could be etched with a fluorocarbon-based plasma (e.g. CHF₃ for SiOₓ and pad oxide, and C₄F₈ for Si₃N₄).

We now refer to Fig. 3. The pattern was then transferred into the semiconductor substrate (100) by etching through the trenches (300) down to a first depth (di; e.g. 50 nm into the semiconductor substrate). For this etching, a chemistry pulsing was used, comprising cycles alternating a Cl₂-based plasma etch and an O₂-based (or O₂/N₂) passivation. This type of etching resulted in an extension of the trenches (300) straight down into the semiconductor substrate (100), thereby forming a first (upper) portion (410) of the fin structures (400) with a straight profile and an intermediate height (h₁).

We now refer to Fig. 4. A patterning stack (500) is provided on the semiconductor substrate (100) comprising an SoC layer (510), an SoG layer (520) and a resist layer (530). The resist layer (530) was patterned (e.g. photolithographically) with a suitable KEEP pattern. The KEEP pattern could, for example, correspond to the removal of the terminal fin structures (401) and/or to the removal of one or more inner fin structures (402).

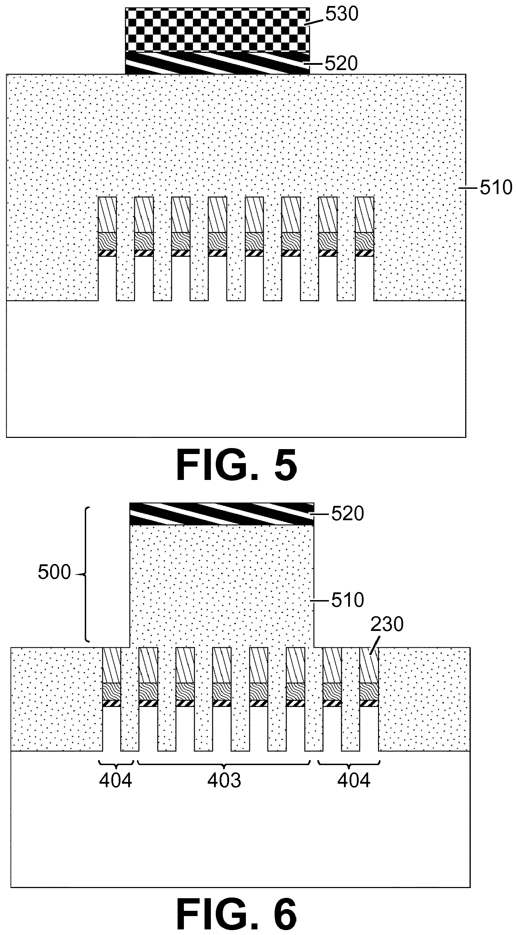

We now refer to Fig. 5. The KEEP pattern of the resist layer (530) was transferred through the SoG layer (520), down to the SoC layer (510). The etch chemistry used could be as previously described for the CUT patterning.

We now refer to Fig. 6. The KEEP pattern was transferred through the SoC layer (510), down to the top of the SiOₓ hardmask layer (230) overlaying the fin structures (400). The etch chemistry used could be as previously described for the CUT patterning. This etching also removed the remaining resist layer (530).

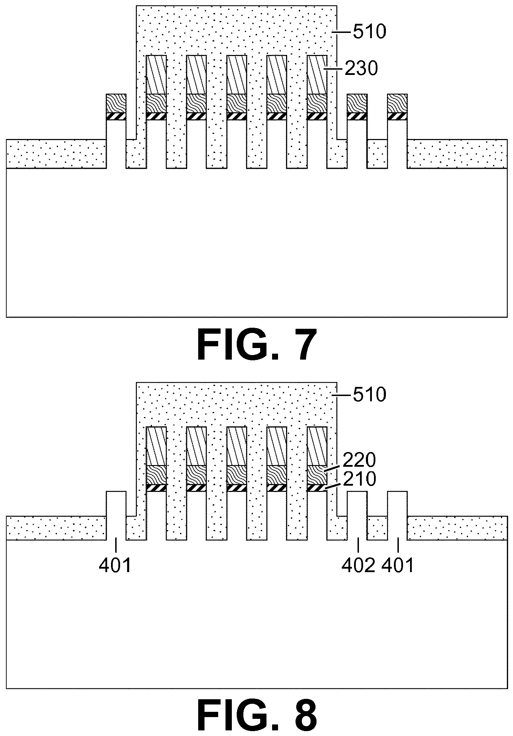

We now refer to Fig. 7. The etching of the SoC layer (510) was continued, thereby removing the exposed SiOₓ hardmask layer (230) overlaying the fin structures (400). This etching also removed the remaining SoG layer (520).

We now refer to Fig. 8. The etching of the SoC layer (510) was continued, thereby removing the exposed Si₃N₄ pad layer (220) and pad oxide layer (210) and exposing the fin structures (401, 402).

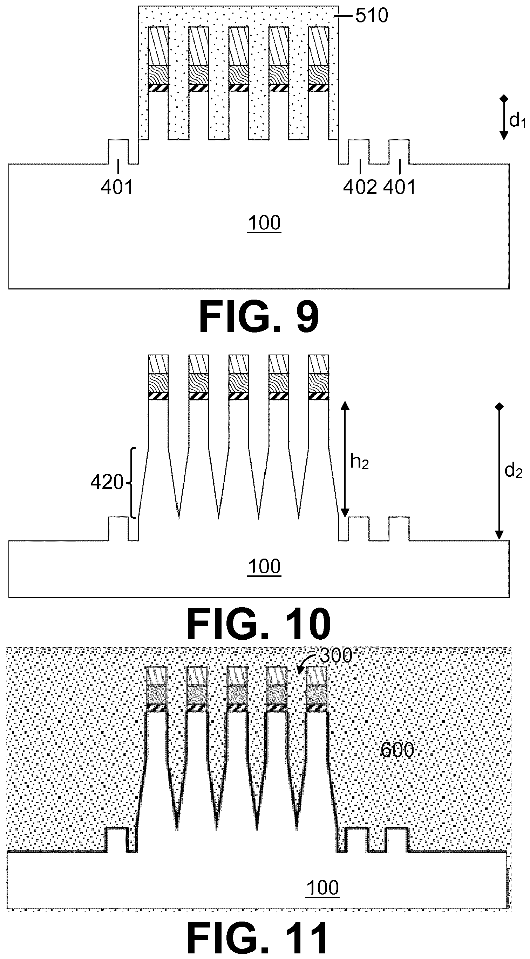

We now refer to Fig. 9. The etching of the SoC layer (510) was continued, thereby also etching down the exposed fin structures (401, 402), down to (and optionally further than) the first depth (di) of the semiconductor substrate (100). An halogen-based etching can be used to etch Si selectively to SoC.

We now refer to Fig. 10. The SoC layer (510) was etched further and the semiconductor substrate (100) was etched further down to a second depth (d₂; e.g. down to a total depth of 120 nm), both selectively with respect to the SiOₓ hardmask layer (230). For this etching, a bias pulsing was used, comprising a Cl₂-based plasma etch with additives (e.g. NF₃); optionally combined with a chemistry pulsing as described earlier. The bias pulsing etch was used to extend the trenches (300) down with tapering width, thereby increasing the height (h₂) of the fin structures (400) by forming a second portion (420) thereof with a profile flaring towards the bottom.

We now refer to Fig. 11. An oxide layer (600) (e.g. SiO₂) was provided over the semiconductor substrate (100) and fin structures (400).

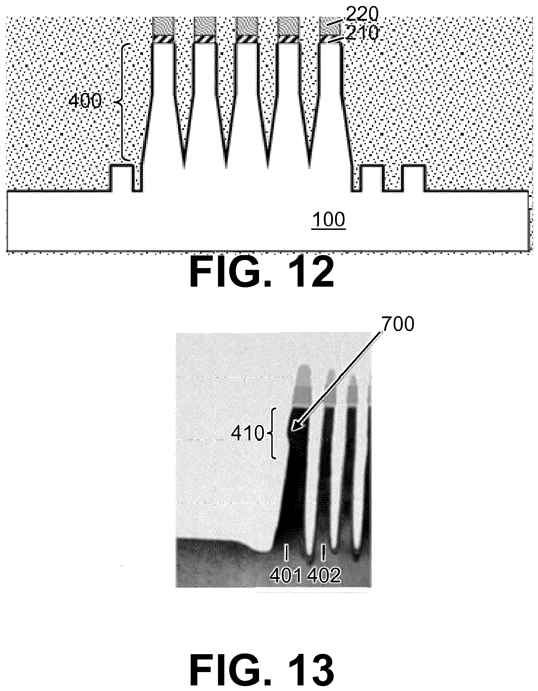

We now refer to Fig. 12. The SiOₓ hardmask layer (230) and oxide layer (600) were removed, selectively with respect to the Si₃N₄ pad layer (220) by CMP, pad oxide layer (210), semiconductor substrate (100) and fin structures (400), in a post-etch cleaning step using diluted HF.

### Example 2: patterning fin structures using a CUT& KEEP-middle scheme

Example 1 is repeated, but both the KEEP and the CUT patterning are performed after the formation of the first portion of the fin structures (e.g. as described for Fig. 3). The CUT patterning could be achieved as described for the KEEP patterning in example 1 and could be performed before, after or concurrently with (e.g. using a resist layer with a combined pattern) the KEEP patterning. Performing the CUT patterning before or after the KEEP patterning could comprise performing either of both patternings akin to the description for Figs. 4-7 and subsequently performing the other patterning, again akin to the description for Figs. 4-7.

### Comparative example: patterning fin structures using a CUT&KEEP-first scheme

Fin structures were patterned into a semiconductor substrate using a CUT-first and no KEEP scheme. Similar materials, etch chemistries and procedures as described for the previous example were used, with the exception that CUT patterning was performed prior to transferring the initial fin pattern into the semiconductor substrate. The KEEP patterning was skipped but could be achieved as described for the CUT patterning in example 1 and could be performed before, after or concurrently with (e.g. using a resist layer with a combined pattern) the CUT patterning.

Fig. 13 depicts scanning electron microscopy (SEM) images of a comparative sample obtained according to the comparative example. A protrusion (700) (which may also be referred to as a kink) is visible in a first portion of the terminal fin structure (401). This first portion typically corresponds to the location where a channel of a fin field effect transistor (FinFET) would typically be formed using the fin structures, so a variation in shape between the terminal fin structure (401) and an inner fin structure (402) directly results e.g. in an undesired inequality in the electrical characteristics and behaviour of terminal and inner FinFETs.

It is to be understood that although preferred embodiments, specific constructions and configurations, as well as materials, have been discussed herein for devices according to the present invention, various changes or modifications in form and detail may be made without departing from the scope and technical teachings of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for forming fin structures (400) of a selected height (h₂) into a semiconductor substrate (100), comprising:
a. providing the semiconductor substrate (100) masked by a first mask (200) comprising openings (300) in the shape of trenches;
b. etching the semiconductor substrate (100) down to a first depth (di) selectively with respect to the first mask (200), thereby forming intermediate fin structures (410) having an intermediate height (hi), smaller than the selected height (h₂) into the semiconductor substrate (100);
c. providing a second mask (500) over the first mask (200), the second mask (500) masking at least partially a first subset (403) of the intermediate fin structures (410) while not masking a second subset (404) thereof;
d. etching at least partially the second subset (404) of the intermediate fin structures (410);
e. removing the second mask (500); and
f. etching the semiconductor substrate (100) down to a second depth (d₂) selectively with respect to the first mask (200), thereby forming the fin structures (400) having the selected height (h₂) from the intermediate fin structures (410).

2. The method according to claim 1, further comprising a step b' after step b and before step c of filing a space between the intermediate fin structures (410) with a filling material (510) and a step e' after step e and before step f of removing the filing material (510) from between the intermediate fin structures (410).

3. The method according to any of the previous claims, further comprising a step g, after step f, of removing the first mask (200).

4. The method according to any of the previous claims, wherein etching at least partially the second subset (404) of the intermediate fin structures (410) in step d comprises reducing the height of the intermediate fin structures (410) of the second subset (404) obtained in step b by 50% or more.

5. The method according to any of the previous claims, wherein the second subset (404) comprises a terminal intermediate fin structure (401) of the intermediate fin structures (410), having only one adjacent intermediate fin structure.

6. The method according to any of the previous claims, wherein the etching in step b is performed such that a volume (v) thereby etched-away has a uniform width (w).

7. The method according to any of the previous claims, wherein the etching in step f is performed such that a volume thereby etched-away has a width which tapers from the first depth (di) to the second depth (d₂).

8. The method according to any of the previous claims, wherein the first depth (di) measures between 20 and 100 nm.

9. The method according to any of the previous claims, wherein the second depth (d₂) measures at least 50 nm.

10. The method according to any of the previous claims, wherein the openings (300) have a width of from 5 to 20 nm.

11. The method according to any of the previous claims, wherein the semiconductor substrate (100) is formed of Si, Ge, SiGe or multilayers thereof.

12. The method according to any of the previous claims, wherein the first mask (200) comprises an oxide material.

13. The method according to any of the previous claims, wherein the second mask (500) comprises one or more layers independently selected from a spin-on-carbon layer (510), a spin-on-glass layer (520) and a resist layer (530).

14. An intermediate structure for forming fin structures (400) of a selected height (h₂) into a semiconductor substrate (100), comprising:
i. a semiconductor substrate (100) having intermediate fin structures (400) therein;
ii. a first mask (200) masking all intermediate fin structures (400) and comprising openings (300) aligned with spaces between the intermediate fin structures;
iii. a second mask (500) over the first mask (200), the second mask (500) masking at least partially a first subset (403) of the intermediate fin structures (410) while not masking a second subset (404) thereof.
